Europäisches Patentamt

**European Patent Office**

**Office européen des brevets**

(11) Numéro de publication: **0 292 390 B1**

## (12) FASCICULE DE BREVET EUROPEEN

(45) Date de publication de fascicule du brevet: **03.08.94** (51) Int. Cl.⁵: **H01L 21/306**

(21) Numéro de dépôt: **88401214.7**

(22) Date de dépôt: **19.05.88**

Le dossier contient des informations techniques présentées postérieurement au dépôt de la demande et ne figurant pas dans le présent fascicule.

(54) **Procédé de gravure anisotrope d'un matériau III-V : application au traitement de surface en vue d'une croissance épitaxiale.**

(30) Priorité: **21.05.87 FR 8707135**

(43) Date de publication de la demande:
**23.11.88 Bulletin 88/47**

(45) Mention de la délivrance du brevet:
**03.08.94 Bulletin 94/31**

(84) Etats contractants désignés:
**CH DE GB LI NL SE**

(56) Documents cités:

**LE VIDE, LES COUCHES MINCES, vol. 41, no. 231, mars/avril 1986; pages 259-260,Paris, FR; L. HENRY et al.: "Première approche de la gravure ionique de couchesde GaInAs epitaxiées sur InP"**

**Nuclear Instruments and Methods in Physics Research B7/8 (1985), pages 814-818**

**Le Vide, les Couches Minces - Supplément au No. 248, Août-Septembre-Octobre 1989, page 33**

(73) Titulaire: **FRANCE TELECOM**
**6, Place d'Alleray**
**F-75015 Paris(FR)**

(72) Inventeur: **HENRY, Loic**
**25, rue de Kerpabu Servel**
**F-22300 Lannion(FR)**
Inventeur: **VAUDRY, Claude**
**Le Bourg**
**F-22300 Lanmerin(FR)**

(74) Mandataire: **Dubois-Chabert, Guy et al**
**Société de Protection des Inventions**
**25, rue de Ponthieu**
**F-75008 Paris (FR)**

Rank Xerox (UK) Business Services
(3.10/3.09/3.3.3)

Electronics Letters, vol. 27, no. 11, 23rd May 1991, pages 926-927

Properties of Indium Phosphide, INSPEC, EMIS Datareviews Series no. 6, 1991, pages 346-349 et page 338

Inst. Phys. Conf. Ser. no. 79: Chapter 6, 1986, pages 367-372

## Description

L'invention a pour objet un procédé de gravure anisotrope du type ionique réactive d'un matériau III-V permettant notamment la réalisation de structures semi-conductrices épitaxiées, utilisables dans le domaine de la microélectronique et des télécommunications.

En particulier, l'invention peut être utilisée pour réaliser un grand nombre de composants tels que des diodes, des transistors, des dispositifs à transfert de charges, des mémoires, des lasers, des photodétecteurs, des guides optiques, des réseaux, etc. ainsi que l'intégration sur un même substrat de ces composants. Ces derniers peuvent être réalisés sous forme d'une homo- ou hétérostructure.

On rappelle qu'un matériau III-V est un matériau contenant au moins un élément de la colonne III et au moins un élément de la colonne V de la classification périodique des éléments.

La réalisation de structures semi-conductrices en matériau III-V passe généralement par la réalisation d'une gravure d'une couche ou d'un substrat en matériau III-V.

Pour la gravure de ces matériaux, les techniques dites "humides" sont limitées par le caractère isotrope de l'attaque chimique, ce qui ne permet pas d'obtenir des motifs gravés de dimensions microniques voir submicroniques.

De plus, la gravure humide manque de reproductibilité en ce qui concerne les vitesses d'attaque, ce qui pose parfois des problèmes lors de la fabrication industrielle de composants électroniques tels que les transistors MESFET et les lasers.

Les techniques de gravure sèche utilisées en microélectronique silicium on fait récemment leur apparition pour la gravure des semi-conducteurs III-V. Malheureusement, les gaz fluorés les plus employés en technologie silicium ne peuvent pas convenir pour les composés III-V étant donné que les produits de réaction obtenus ne sont pas volatils. C'est pourquoi les gaz utilisés pour les gravures des matériaux III-V sont généralement des gaz chlorés ou bromés tels que $SiCl_4$, $Cl_4$, $CF_2Cl_2$, $BCl_3$, $Cl_2$ ou $Br_2$.

Cependant, l'emploi de ces gaz chlorés ou bromés pose de nombreux problèmes de sécurité et de corrosion des équipements de gravure. De plus, certains laboratoires ont constaté des problèmes de fiabilité sur les composants réalisés avec une étape de gravure ionique réactive chlorée.

En particulier, on a remarqué que des résidus de chlore demeurent la surface du matériau gravé et réagissent ensuite avec les métallisations de contact.

Plus récemment, on a envisagé de graver de l'InP avec un mélange de $CH_4$ et d'hydrogène comme décrit dans l'article Inst. Phys. Conf. Ser. n°79 : chapitre 6-1986 de U. Niggebrügge et al., pp. 367, intitulé "A novel process for reactive ion etching on InP using $CH_4/H_2$". Les gravures sont réalisées en utilisant un masque de résine photosensible.

Ce procédé connu présente un certain nombre d'inconvénients. En particulier, il se forme en surface du masque de résine une couche de polymères, épaisse et non homogène, par réaction entre les gaz $CH_4$ et $H_2$ qui est très difficile à enlever, même en utilisant un plasma d'oxygène de forte puissance comme indiqué dans la publication. Du fait de la formation de ces polymères, le masque de résine est très difficile à retirer. En outre, le procédé de gravure n'est pas reproductible.

Par ailleurs, l'état de surface du matériau gravé n'est pas de qualité satisfaisante pour un grand nombre d'applications ; les flancs de gravure présentent trop d'irrégularités et les puissances radiofréquences utilisées pour l'ionisation des gaz sont très élevées, ce qui peut entraîner une détérioration de la surface du matériau gravé par le bombardement ionique.

La gravure de GaInAs avec un mélange de $H_2$, Ar et 15% $CH_4$ est décrite dans l'article Le Vide, Les Couches Minces, vol. 41, no. 231, mars/avril 1986, pages 259-260, Paris, FR, L. Henry et al.: "Première approche de la gravure ionique de couches de GaInAs epitaxiées sur InP.". L'état de surface de la couche de GaInAs, avant et après gravure, est identique.

Comme autre technique de gravure connue des matériaux III-V, on peut citer l'usinage ionique. Cette technique est en particulier utilisée pour la fabrication de guides optiques enterrés. Malheureusement, cette technique de gravure est peu sélective, ce qui nécessite l'utilisation de masques très épais (plusieurs micromètres) en matériau réfractaire, titane par exemple. En outre, la nature et la quantité de matériau nécessaires la réalisation de ces masques confèrent à cette technique un coût élevé.

Le but de l'invention est donc de trouver des conditions de gravure donnant à la fois une gravure anisotrope et un état de surface lisse du matériau gravé, sans résidu sur les fonds de gravure. En outre, l'état de surface des parties gravées doit être de bonne qualité de façon à pouvoir réaliser, sans autre traitement, les étapes de dépôt d'une couche semi-conductrice par épitaxie, de dépôt de couches isolantes ou de couches conductrices.

D'autre part, les vitesses de gravure doivent être facilement modulables de façon à contrôler de manière très précise, les profondeurs gravées. Ce paramètre est très important car il est très souvent nécessaire, pour la réalisation de dispositifs semi-conducteurs, de graver de faibles épaisseurs (inférieures à 300 nm ± 5% pour un transistor FET sur GaAs) ou de contrôler l'arrêt d'une attaque au niveau d'une interface, (cas des hétérostructures lasers par exemple).

Or, pour atteindre ces objectifs, la difficulté majeure réside dans le choix du gaz d'attaque. Il faut en effet, trouver un mélange gazeux qui, sous l'effet d'ondes radiofréquences, ait la même cinétique de réaction avec les éléments de la colonne III (Al, Ga, In) et ceux de la colonne V (P, As, Sb).

En outre, les composés III-V à graver sont très variés ; les matériaux à graver peuvent être des matériaux massifs ou bien des couches superposées de composition ou de dopage différent.

L'invention concerne un procédé de gravure du type ionique réactive de matériau III-V permettant de remédier aux différents inconvénients donnés ci-dessus ainsi que de satisfaire aux exigences sus-mentionnées.

En particulier, le procédé de l'invention est parfaitement reproductible, et parfaitement anisotrope ; les parties gravées sont de bonne qualité et les fonds de gravure présentent une surface lisse. En outre, les vitesses de gravure sont facilement modulables.

De façon plus précise, l'invention a pour objet un procédé de gravure ionique réactive d'un matériau III-V utilisant un mélange de gaz tel que defini dans la revendication 1.

L'utilisation d'une quantité de gaz inerte, notamment d'argon, supérieure à 55% entraîne une prédominance de la gravure ionique due au mélange gaz inerte + hydrogène, par rapport à la gravure réactive qui est due à la réaction de l'hydrogène et de l'hydrocarbure avec le matériau III-V. En revanche, une quantité de gaz inerte inférieure à 20% entraîne la formation de fond de gravure rugueux et de flancs de gravure de mauvaise qualité.

Par ailleurs, une trop grande quantité d'hydrocarbure gazeux au moins égale à 40% favorise la formation de polymères et l'isotropie de gravure, ce qui est très gênant lors de gravure localisée nécessitant l'emploi d'un masque de gravure, alors qu'une quantité trop faible d'hydrocarbure, au plus égale à 15%, n'est pas suffisante pour permettre des réactions du type organo-métallique avec les éléments III du matériau à graver.

Il est surprenant de voir qu'une grande quantité de gaz rare, notamment d'argon, pouvant aller jusqu'à plus de 50% en volume, conduit à une gravure d'excellente qualité car il est bien connu de l'homme de l'art que l'argon seul est couramment utilisé pour un usinage ionique, ce qui correspond à une destruction de l'état de surface du matériau III-V.

La proportion du gaz inerte dans le mélange gazeux est très importante pour obtenir une gravure de bonne qualité.

En effet, l'hydrocarbure gazeux réagit avec l'élément III pour former des composés organo-métalliques tandis que l'hydrogène réagit avec l'élément V pour former des hydrures.

Utilisant $CH_4$ comme hydrocarbure et de l'indium ou du gallium comme élément V, on forme des composés du type triméthylindium ou triméthylgallium qui sont des composés volatils. De même, l'hydrogène avec l'arsenic et le phosphore, forment respectivement les hydrures $AsH_3$ et $PH_3$ qui sont aussi volatils.

Dans ces processus chimiques, l'argon semble activer la surface à graver en y excitant les atomes des éléments III et V, favorisant ainsi les réactions respectives de ces éléments avec les radicaux alkyle $C_nH_{2n+1}$. et l'hydrogène H. résultant de l'excitation de l'hydrocarbure et de $H_2$ par les ondes radiofréquences.

Le procédé selon l'invention est applicable à un grand nombre de matériaux tels que $Ga_{1-x}As_xP$, $GaP$, $GaSb$, $Ga_{1-x}In_xAs_{1-y}Sb_y$, $Ga_{1-x}As_xSb$, $Ga_{1-x}Al_xAs_{1-y}Sb_y$, $InAs_xSb_{1-x}$, $InAs$, $InAs_{1-x}P_x$, $AlAs_{1-x}Sb_x$ ou $AsSb$ avec $0 \leqq x \leqq 1$ et $0 \leqq y \leqq 1$.

Toutefois, l'invention s'applique plus particulièrement au matériau InP, GaAs, GaSb, $Ga_{1-x}In_xAs$, $Ga_{1-x}In_xAs_{1-y}P_y$ et $Ga_{1-x}Al_xAs$ avec $0 \leqq x \leqq 1$ et $0 \leqq y \leqq 1$, les plus couramment utilisés en micro-électronique.

Le matériau III-V à graver peut être un substrat massif ou une couche semi-conductrice reposant sur un substrat massif ou sur un empilement de couches semi-conductrices de natures différentes.

Le procédé de gravure selon l'invention peut être réalisé pour une quelconque orientation des plans cristallins du matériau à graver étant donné que ce procédé est indépendant de ces plans cristallins.

Afin de favoriser l'évacuation des organo-métalliques formés et d'éviter leur redéposition en présence des ondes excitatrices radiofréquences, la gravure ionique selon l'invention doit être réalisée dans une enceinte à vide avec un débit de pompage élevé, au moins égal à 150 $m^3$/h.

Outre la composition du mélange gazeux utilisée pour obtenir une gravure de qualité satisfaisante, les pressions de ce mélange sont aussi importantes. En particulier, la pression du mélange doit être comprise entre 1 et 4 Pa. De préférence, on utilise des pressions allant de 1,5 à 3 Pa.

4

De même, la puissance des ondes radiofréquences utilisées doit varier de 10 à 250 watts et de préférence aller de 10 à 150 watts.

En jouant sur la pression des gaz, sur la vitesse de pompage, la composition des gaz et la puissance radiofréquence, on peut faire varier la vitesse de gravure, ce qui permet un contrôle très précis des profondeurs gravées permettant ainsi de graver un empilement de couches en matériau III-V de façon sélective. En particulier, on peut graver des empilements du type GaInAs/InP/GaInAs/InP ou encore GaInAsP/InP/GaInAs/InP.

La vitesse de gravure croît avec la pression des gaz, la puissance radio fréquence, la quantité de gaz rare et décroît si la vitesse de pompage augmente. En outre, la qualité de la gravure décroît avec la vitesse de gravure ; une vitesse de gravure de 10 à 80 nm/min. est tout à fait satisfaisante.

Le procédé selon l'invention peut être utilisé pour graver en surface et en profondeur tout ou partie d'un matériau III-V.

Une gravure superficielle du type pleine plaque (c'est-à-dire sans masque de gravure) de tout le matériau peut être utilisée avantageusement comme étape de préparation d'un substrat brut en vue de réaliser sur ce substrat le dépôt d'une ou plusieurs couches en matériau III-V par croissance épitaxiale.

Autrement dit, le procédé de gravure selon l'invention peut constituer une étape de préparation de surface d'un substrat III-V efficace ne nécessitant aucune autre étape de préparation de ladite surface, à l'exception d'une désoxydation éventuelle, avant d'épitaxier une couche semi-conductrice en matériau III-V, de composition identique ou différente de celle du substrat.

En effet, les inventeurs ont constaté qu'une épitaxie réalisée sur un substrat préparé conformément à l'invention présentait des qualités cristallines équivalentes à une épitaxie réalisée sur un substrat décapé chimiquement en milieu humide.

Pour fabriquer une structure semi-conductrice, il est généralement nécessaire de réaliser des gravures localisées d'un matériau III-V nécessitant l'emploi d'un masque de gravure représentant l'image des gravures à effectuer.

Pour réussir cette gravure localisée, il est nécessaire que le masque ne soit pas ou que faiblement attaqué lors de la gravure du matériau III-V. Autrement dit, la sélectivité S de la gravure doit satisfaire à la condition suivante : S = vitesse de gravure du matériau III-V/vitesse de gravure du masque > > à 1.

En outre, le masque de gravure doit être facile à enlever et le matériau III-V ne doit pas être altéré par le retrait de ce masque.

Le masque de gravure peut être réalisé en résine photosensible négative ou positive, en un matériau isolant tel que $Si_3N_4$ ou $SiO_2$ ou encore en métal tel que le titane ou l'aluminium.

L'élimination d'un masque en résine photosensible peut être réalisée à l'aide d'un plasma d'oxygène ; l'élimination d'un masque en $SiO_2$ peut être réalisée avec un plasma de $CHF_3$ ou $CF_4$ et l'élimination d'un masque en titane ou aluminium peut être réalisée respectivement avec $HF + H_2O_2 + H_2O$.

De façon avantageuse, on utilise un masque de $Si_3N_4$ étant donné qu'il n'est pas attaqué par le plasma de gravure selon l'invention et qu'il est facile à dissoudre dans de l'acide fluorhydrique pur ou dilué ; la fine couche de polymères qui peut éventuellement se déposer sur ce masque, lors de la gravure du matériau III-V, est alors soulevée puis décollée.

La croissance épitaxiale d'une couche semi-conductrice sur un matériau III-V ayant subi une étape de décapage ionique réactif, conforme à l'invention, comme étape de préparation de surface, peut être du type jet moléculaire (MBE), du type décomposition chimique de vapeurs organométalliques (MOCVD) mettant en jeu des réactions chimiques inverses de celles mises en jeu lors de la gravure du matériau III-V, ou même une épitaxie en phase liquide (LPE).

D'autres caractéristiques et avantages de l'invention ressortiront mieux de la description qui va suivre, donnée à titre illustratif et non limitatif, en référence aux figures annexées, dans lesquelles :
- les figures 1 à 8 sont des clichés de matériaux III-V gravés avec un mélange gazeux de $CH_4/H_2/Ar$ de composition ou de pression différente ; les figures 1 à 6 montrent l'influence de la composition du gaz sur le profil de gravure et les figures 7 et 8 l'influence de la pression sur ce profil,
- la figure 9 est une spectroscopie de photoélectrons XPS d'un substrat en InP gravé selon le procédé de l'invention,
- les figures 10 et 11 illustrent les différentes étapes de fabrication d'une couche semi-conductrice enterrée en matériau III-V dans un substrat semi-isolant en matériau III-V, fabrication utilisant le procédé de gravure de l'invention,
- la figure 12 illustre les différentes étapes de fabrication d'un transistor MESFET comportant une couche semi-conductrice enterrée, et
- la figure 13 illustre la fabrication d'une source laser utilisant le procédé de gravure de l'invention.

Le procédé selon l'invention consiste à graver un matériau III-V de façon anisotrope en utilisant un plasma gazeux formé par excitation radiofréquence d'un mélange gazeux contenant, en volume, 20% $CH_4$, 50% Ar et 30% $H_2$. Cette gravure peut être réalisée sous une pression gazeuse comprise entre 1 et 4 Pa avec une puissance radiofréquence allant de 10 à 250 watts.

Elle peut être réalisée dans tout dispositif de gravure ionique réactive (GIR en abrégé) actuellement connu. Le principe de fonctionnement d'un certain nombre d'appareils de gravure GIR est notamment décrit dans le document VLSI Technology de Sze paru chez International Student Edition.

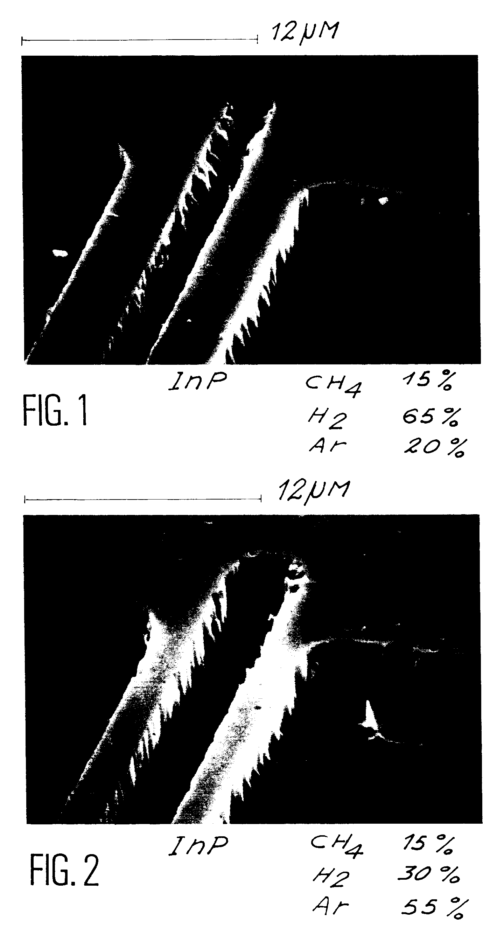

Les figures 1 à 5 sont relatives à une gravure localisée d'un substrat massif en InP, utilisant un masque de gravure en $Si_3N_4$ de 100 nm d'épaisseur. La pression du mélange gazeux est de 2,2 Pa ; la puissance radiofréquence est de 10 watts ; le débit de pompage est de 300 $m^3$/h ; les compositions gazeuses et les vitesses de gravure respectives sont données dans le tableau ci-après, les compositions étant exprimées en volume % et les vitesses en nm/min.

### T A B L E A U

| Figures | $CH_4$ | $H_2$ | Ar | Vitesse |
|---------|--------|-------|-----|---------|
| 1 | 15 | 65 | 20 | 60 |
| 2 | 15 | 30 | 55 | 65 |
| 3 | 10 | 50 | 40 | 40 |
| 4 | 40 | 10 | 50 | 70 |
| 5 | 20 | 30 | 50 | 65 |

Les profondeurs de gravure sont de 2 $\mu$m environ.

Les échelles des différentes photos sont indiquées sur les figures correspondantes.

Des figures 1 à 5, il ressort clairement que, dans les mêmes conditions de pression et de puissance radiofréquence, seule la composition gazeuse conforme à l'invention permet d'obtenir une bonne gravure anisotrope avec des flancs de gravure sont nets et perpendiculaires à la surface du matériau et des fonds de gravure sont lisses et sans résidu de matériau.

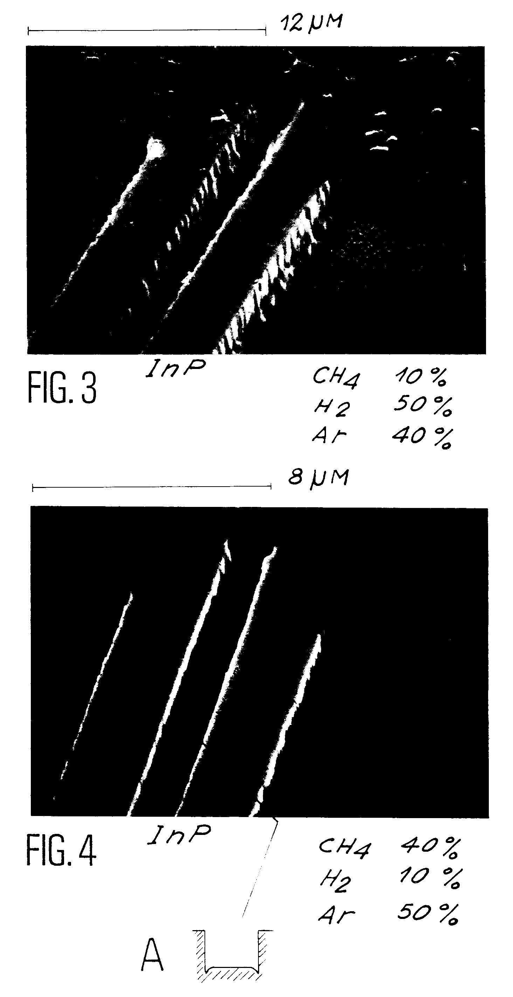

En effet, sur les figures 1 à 4, les flancs de gravure sont frangés. En outre, sur la figure 3, le fond de gravure est rugueux ; ceci est dû à un résidu d'indium.

Par ailleurs, sur la figure 4, on constate une surgravure trop importante au pied des flancs de gravure ; la partie A de la figure 4 illustre le profil des flancs de gravure obtenu.

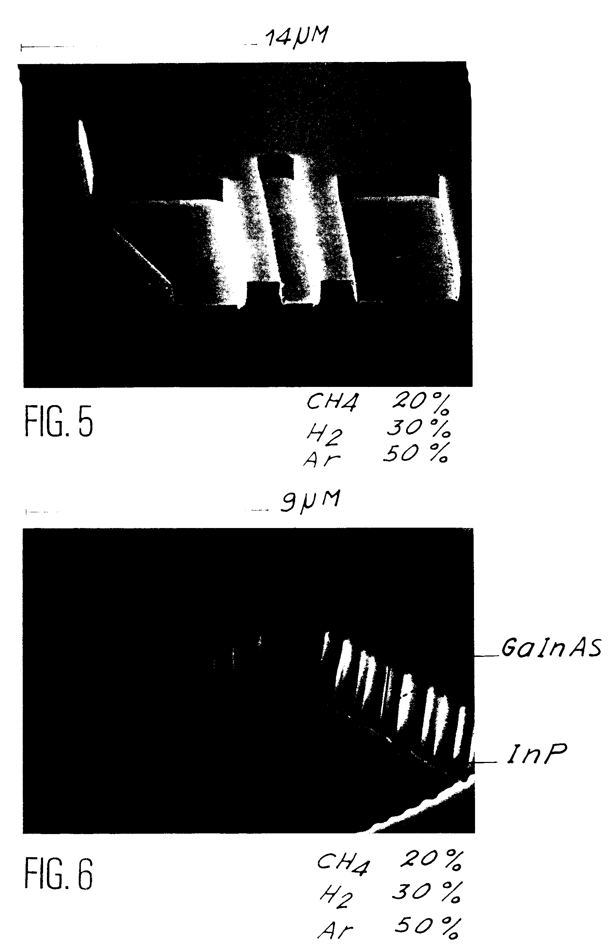

Des résultats identiques à ceux illustrés sur la figure 5 ont été obtenus pour un substrat massif en GaAs et en GaSb sur une profondeur de 1,5 $\mu$m et pour un substrat en $Ga_{1-x}Al_xAs$ avec x égal à 0,3 sur une profondeur de 600 nm avec un mélange gazeux de $CH_4 + H_2 + Ar$ dans les proportions 20/30/50% en volume.

La figure 6 est relative à une gravure d'une couche de $Ga_{1-x}In_xAs$ avec x égal à 0,53, ayant une épaisseur de 1,5 $\mu$m, épitaxiée sur un substrat en InP. La gravure ionique réactive est effectuée sur une épaisseur de 2,7 $\mu$m avec un mélange gazeux de $CH_4 + H_2 + Ar$ dans les proportions en volume 20/30/50%, sous une pression de 2,2 Pa et une puissance RF de 100W.

Les ondulations parfaitement régulières obtenues sur les flancs de gravure (du type "moule à tarte") sont dues à la définition du masque de gravure en nitrure de silicium.

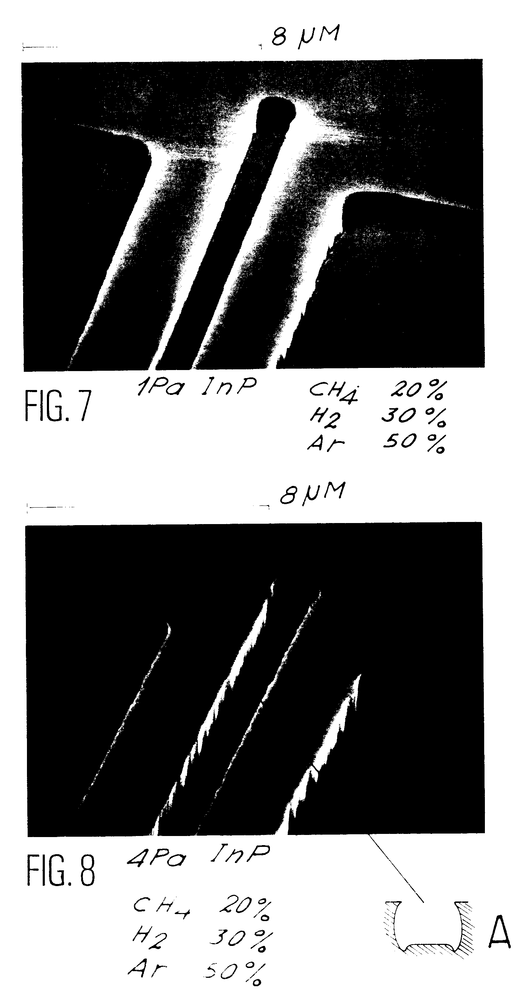

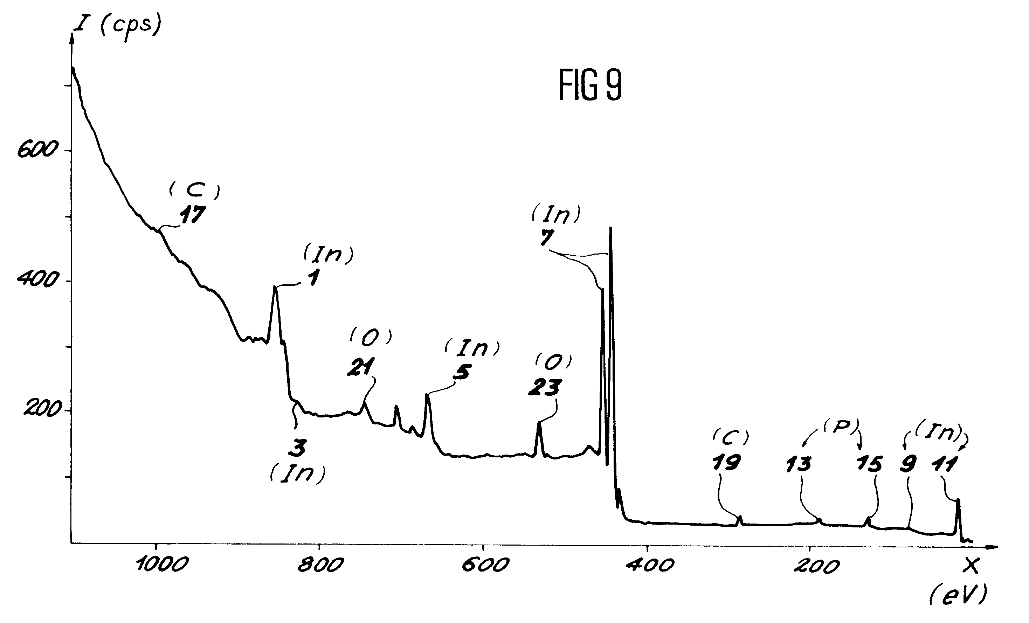

Les figures 7 et 8 sont relatives à une gravure d'un substrat massif en InP, utilisant un masque de nitrure de silicium, avec une puissance radiofréquence de 100 watts et un mélange gazeux de $CH_4/H_2/Ar$ de composition en volume % 20/30/50. Les pressions utilisées étaient respectivement de 1 Pa et de 4 Pa.

Il ressort de ces figures que l'utilisation d'une pression au plus égale à 1 Pa ou d'une pression au moins égale à 4 Pa ne permet pas d'obtenir une gravure anisotrope de qualité suffisante.

En effet, une pression trop faible conduit à des fonds de gravure granuleux (figure 7) alors qu'une pression trop importante conduit-l'obtention de flancs gravés de forme concave, et donc par conséquent, non abrupts, ainsi qu'à une sur-gravure trop importante au pied des flancs de gravure. La partie A de la figure 8 illustre le profil des flancs de gravure obtenu.

Le procédé de gravure selon l'invention permet d'obtenir des zones gravées de bonne qualité cristalline ne comportant pas de pollution métallique, contrairement à ce qui se passe généralement dans les réacteurs à plasma (les pollutions métalliques proviennent des électrodes radiofréquences et des parois en métal du réacteur). Ceci ressort clairement de la spectroscopie XPS représentée sur la figure 9 effectuée sur un substrat massif en InP avec un mélange gazeux $CH_4 + H_2 + Ar$ de composition en volume % 20/30/50, sous une pression de 2,2 Pa, avec une puissance radiofréquence de 100 W et un débit de pompage de 300 $m^3$/h.

L'intensité photoéleectronique I émise par l'échantillon, en ordonnées, est exprimée en coup par seconde (cps) et l'énergie des rayons X, en abscisses, est exprimée en électron-volts.

Les pics d'émission 1, 3, 5, 7, 9, 11 les plus nombreux, sont dus à l'indium du substrat ; les pics 13 et 15 sont dus au phosphore du substrat ; les pics 17 et 19 sont dus à des impuretés de carbone provenant de la remise à l'air libre de l'échantillon. Il en est de même pour les impuretés d'oxygène correspondant aux pics d'émission 21, 23. Ces traces de C et de $O_2$ sont en quantité négligeable.

Aucun pic dû à la présence d'impuretés métalliques dans l'échantillon n'apparaît sur le spectre d'émission.

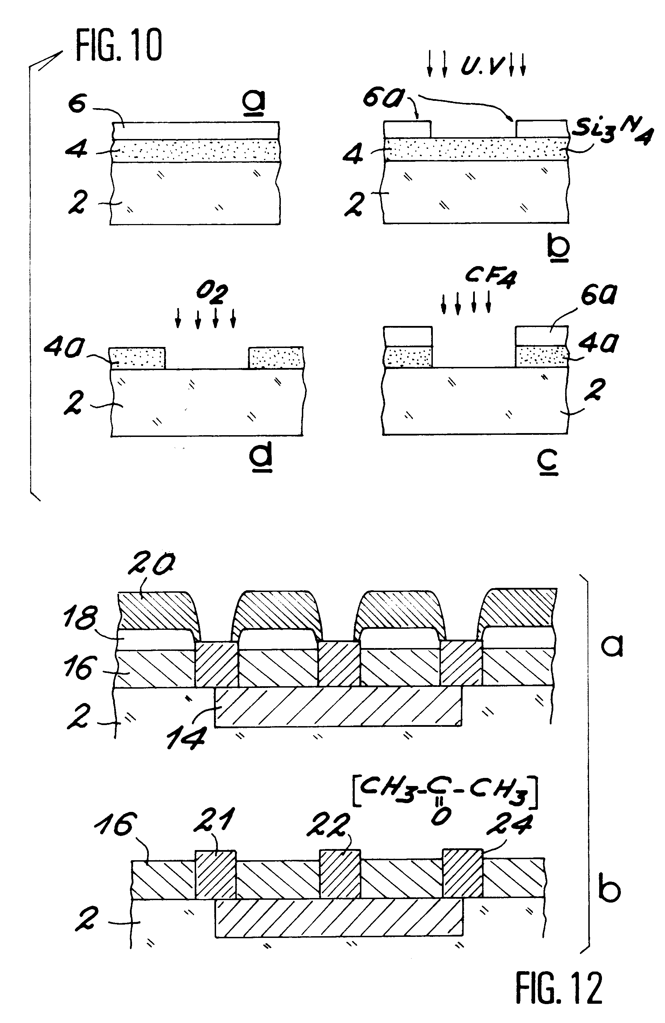

Le procédé de gravure selon l'invention peut être utilisé pour la réalisation de structures semi-conductrices, comportant en particulier une couche semi-conductrice épitaxiée et enterrée, telles que les transitors MESFET, les guides de lumière et les réseaux. A cet effet, on a représenté sur les figures 10 à 11, les différentes étapes de fabrication d'une couche semi-conductrice épitaxiée et enterrée.

Les premiéres étapes de cette fabrication, représentées sur la figure 10, illustrent les étapes de préparation d'un masque en nitrure de silicium devant servir à la gravure d'un matériau semi-isolant du type III-V.

Le substrat semi-isolant 2 par exemple en InP est tout d'abord comme indiqué en (a) recouvert d'une couche de nitrure de silicium 4 de 100 nm d'épaisseur par pulvérisation cathodique réactive ou dépôt chimique en phase vapeur (CVD) puis d'une couche de résine photosensible positive 6 telle que celle classiquement utilisée en photolithographie (AZ Shippley par exemple) sur une épaisseur de 1000 nm environ.

A travers un photomasque représentant l'image de la gravure à effectuer dans le substrat 2, on insole, en lumière ultraviolette, la résine puis on la développe, les régions non insolées de la résine étant alors dissoutes. On obtient alors le masque de photolithographie 6a représenté sur la partie (b) de la figure 10.

On effectue ensuite une gravure de la couche de nitrure de silicium 4, à travers le masque 6a, à l'aide d'un plasma de $CF_4$. Cette gravure permet, comme représenté sur la partie (c), d'éliminer les régions de la couche de nitrure de silicium non recouvertes de résine. Puis on élimine, grâce à un plasma d'oxygène, le masque de résine 6a.

Le masque en nitrure de silicium 4a obtenu, représenté en (d), peut alors être utilisé comme masque de gravure du substrat semi-isolant 2.

En variante, on peut utiliser un masque de gravure formé d'un matériau bicouche $SiO_2$-$Si_3N_4$.

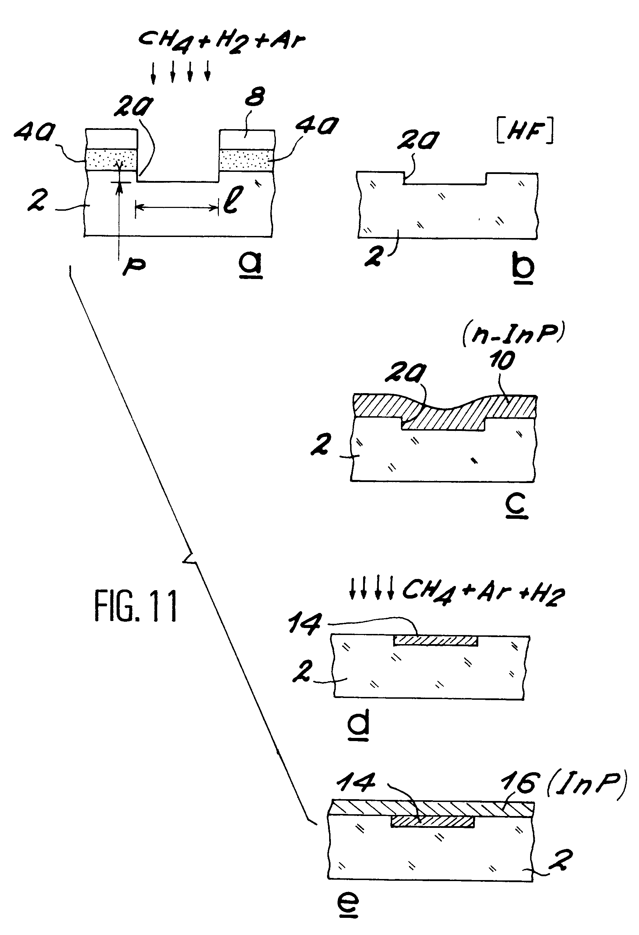

On effectue alors, l'élimination des régions du substrat non recouvertes de $Si_3N_4$, comme représenté sur la partie (a) de la figure 11. Cette gravure est réalisée avec un mélange de gaz $CH_4 + H_2 + Ar$ de composition gazeuse en volume % 20/30/50, sous une pression de gaz de 2,2 Pa, un pompage continu de 300 $m^3$/h et une puissance radiofréquence de 100 watts. Dans ces conditions, on obtient une vitesse de gravure de 60 à 70 nm/min. de l'InP.

Pour la réalisation d'un MESFET, la profondeur p de la zone gravée 2a du substrat 2 est de 200 nm environ et sa largeur de quelques micromètres. De même, pour la réalisation d'un guide optique enterré, la profondeur de gravure p est voisine de 3 $\mu$m et la largeur l de la zone gravée 2a est de l'ordre de 2 $\mu$m.

Parallèlement à la gravure locale du substrat 2, il se forme un film 8 mince et homogène de polymères à la surface du masque 4a en $Si_3N_4$. A l'aide d'une solution concentrée ou diluée d'acide fluorhydrique, on obtient, comme représenté sur la partie (b) de la figure 11 l'élimination totale du masque de gravure 4a ainsi que celle du film 8 de polymères éventuellement formé.

On effectue alors une gravure pleine plaque superficielle du substrat avec un mélange de gaz $CH_4 + H_2 + Ar$ de composition en volume % 20/30/50, avec les mêmes conditions de pression et de débit gazeux que celles utilisées lors de la gravure locale du substrat (figure 11(a)), mais avec une puissance radiofréquence de 20 watts environ. Le décapage est réalisé sur 50 nm pendant 2 minutes.

On effectue alors comme représenté sur la partie (c) de la figure 11, une épitaxie d'une couche 10 de InP dopé n par du silicium. Cette couche déposée par décomposition chimique d'organo-métallique en phase vapeur (MOCVD), ou par épitaxie par jet moléculaire (MBE), présente une épaisseur de quelques micromètres.

Grâce à la réalisation du décapage ionique réactif avant épitaxie, on obtient une épitaxie de bonne qualité cristalline sur toute la surface du substrat.

Si l'on n'avait pas effectué cette étape de préparation de surface du substrat 2, seule l'épitaxie sur la zone gravée 2a aurait donné une couche de bonne qualité cristalline, tandis que la couche épitaxiée sur les zones non gravées, donc protégées par le masque $Si_3N_4$ aurait présenté un aspect tourmenté de type polycristallin. Ceci tient au fait que le substrat non gravé présente des qualités de surface inférieures à celles du matériau gravé.

On effectue ensuite une gravure ionique réactive de la couche 10, conformément à l'invention, dans les mêmes conditions opératoires que celles décrites en référence à la figure 11(a). La structure plane obtenue est alors celle représentée sur la partie (d) de la figure 11. La configuration finale de la couche épitaxiée semi-conductrice, porte alors la référence 14.

Dans le cas d'utilisation d'un masque de gravure bicouche $Si_3N_4$-$SiO_2$, on effectue, après la gravure conforme à l'invention du substrat, l'élimination de la couche supérieure en $SiO_2$ et du film de polymères éventuellement formé, dans une solution de HF dilué, puis le dépôt MOCVD de la couche semi-conductrice 10 et enfin l'élimination du masque de $Si_3N_4$, entraînant simultanément l'élimination des régions de la couche 10 surmontant le masque.

L'étape suivante, comme représenté sur la figure 11(e), consiste à enterrer la couche semi-conductrice 14 en déposant sur l'ensemble de la structure une couche semi-isolante 16 en matériau III-V, par exemple en InP, par croissance épitaxiale du type MOCVD ou bien une couche isolante de passivation en $SiO_2$ par exemple. Cette couche 16 présente une épaisseur d'environ 200 nm.

La structure ainsi obtenue peut alors servir soit comme guide optique enterré, soit pour la réalisation d'un transistor MESFET passivé.

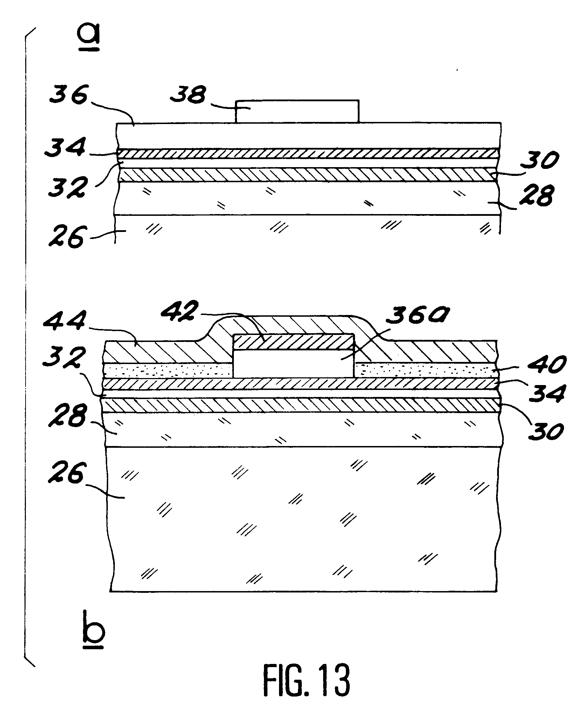

Comme représenté sur la figure 12, la réalisation d'un transistor MESFET en technologie III-V consiste à déposer sur la couche isolante 16 une couche de résine telle que celle classiquement utilisée en photolithographie dans laquelle on forme, comme décrit précédemment (figures 10(a)-10(b)), un masque de lithographie représentant l'image de la source, du drain et de la grille du transitor à réaliser.

A l'aide du masque de résine 18 obtenu, on effectue une nouvelle gravure GIR, dans les mêmes conditions opératoires que celles utilisées en référence à la figure 11(a), sur une profondeur de 200 nm.

Puis on dépose par pulvérisation cathodique sur la structure obtenue, une couche conductrice 20 formée en particulier de deux couches superposées d'or et de germanium. On effectue alors un recuit entre 300 et 400°C pour former un alliage d'or et de germanium. Puis, comme représenté sur la partie (b), on élimine le masque de résine 18 ainsi que les parties de la couche métallique 20 situées au-dessus de ce masque, par dissolution dans de l'acétone ; cette technique est connue sous le nom de "lift off".

Les régions de la couche métallique restantes constituent alors respectivement la source 21, la grille 22 et le drain 24 du transitor à effet de champ.

Le procédé de gravure conforme à l'invention peut aussi être utilisé pour la fabrication d'une structure laser telle que représentée sur la figure 13.

On effectue tout d'abord un décapage superficiel du substrat semi-isolant 26 en GaAs, conformément à l'invention afin de favoriser les prises d'épitaxie sur le substrat.

On dépose alors, comme indiqué sur la partie (a), successivement par épitaxie du type MOCVD ou MBE, une couche 28 de GaAs dopé $n^+$ de quelques micromètres d'épaisseur, une couche 30 du type GaAlAs dopé n de 2 $\mu$m d'épaisseur, une couche 32 de GaAs de 100 nm d'épaisseur constituant la couche active du laser, une couche 34 du type GaAlAs dopé p de 2 $\mu$m d'épaisseur, puis une couche 36 de GaAs dopé $p^+$ de 500 nm d'épaisseur dans laquelle sera définie la structure ruban du laser définissant les dimensions de la zone d'émission.

Par les procédés classiques de photolithographie, on réalise alors un masque de résine photosensible 38 permettant de masquer la région de la couche 36 dans laquelle sera définie la zone ruban 36a du laser.

On effectue alors une gravure de la couche 36 avec un mélange gazeux conforme à l'invention et des conditions de pression et de puissance radiofréquence telles que décrites précédemment.

On forme ensuite une couche d'isolant 40 en $Si_3N_4$ par exemple sur la structure obtenue que l'on grave avec un plasma $CF_4$ jusqu'à ce que la zone ruban 36a soit bien dégagée. Puis on élimine le masque de résine 38 par un plasma d'oxygène. La structure obtenue est alors celle représentée sur la partie (b) de la figure 13.

On réalise alors par la technique du "lift off" un contact électrique en AuZn sur le ruban 36a du laser obtenu, puis la ligne d'alimentation électrique 44 en TiAu du ruban par pulvérisation magnétron.

Le procédé de gravure conforme à l'invention peut donc être utilisé pour réaliser comme décrit précédemment des ccomposants discrets (transitors MESFET, structure laser), mais aussi pour réaliser des lasers et des transitors à effet de champ intégrés sur un même substrat.

Le procédé selon l'invention permet d'obtenir une structure anisotrope avec des fonds de gravure parfaitement lisses et des flancs parfaitement rectilignes, sur des épaisseurs et des largeurs submicroniques, ce qui permet une réalisation de guides optiques enterrés, de réseaux et de structures lasers plus facile que les procédés de l'art antérieur. En outre, ces composants optiques ne présentent que peu ou pas de perte de lumière.

Les exemples d'application du procédé de gravure selon l'invention, donnés précédemment, ont bien entendu été donnés à titre illustratif, d'autres structures semi-conductrices (diodes, photodétecteurs, mémoires) pouvant être envisagées.

En outre,les structures lasers et les transitors MESFET précédents peuvent présenter des formes et des empilements de couches différents de ceux décrits et être réalisés en d'autres matériaux III-V. En particulier, la source et le drain du transistor d'effet de champ peuvent être formés dans le substrat semi-isolant par implantation locale d'ions de type n ou p.

## Revendications

1. Procédé de gravure ionique réactive d'un matériau III-V (2, 10, 16, 36) utilisant un mélange de gaz, caractérisé en ce que ce mélange contient, en volume :
   - 20% de méthane,
   - 50% d'argon, et
   - 30% d'hydrogène.

2. Procédé de gravure selon la revendication 1, caractérisé en ce que le mélange gazeux présente une pression comprise entre 1 et 4 Pa.

3. Procédé de gravure selon la revendication 1 ou 2, caractérisé en ce que le mélange gazeux est ionisé par des ondes radiofréquences, la puissance radiofréquence allant de 10 à 250 watts.

4. Procédé de gravure selon l'une quelconque des revendications 1 à 3, caractérisé en ce que l'on grave localement le matériau (2, 16, 36) en utilisant un masque de gravure (4a, 18, 38) représentant l'image de la zone (2a, 36a) à graver.

5. Procédé se gravure selon la revendication 4, caractérisé en ce que le masque (4a) est en nitrure de silicium.

6. Procédé de gravure selon l'une quelconque des revendications 1 à 5, caractérisé en ce que le matériau III-V (2, 10, 16, 36) est choisi parmi InP, GaSb, $Ga_{1-x}In_xAs$, $Ga_{1-x}In_xAs_{1-y}P_y$, GaAs et $Ga_{1-x}Al_xAs$, avec $0 \leq x \leq 1$ et $0 \leq y \leq 1$.

7. Procédé de croissance épitaxiale d'une couche semi-conductrice (10, 13, 28) en un premier matériau III-V, comportant une étape de préparation de la surface du substrat suivie d'une étape de dépôt par épitaxie, caractérisé en ce que la première étape consiste à graver au moins partiellement le substrat (2, 26) conformément à l'une quelconque des revendications 1 à 6.

## Claims

1. Process for the reactive ionic etching of III - V material (2, 10, 16, 36) using a gaseous mixture, characterized in that the gaseous mixture contains by volume 20% methane, 50% argon and 30% hydrogen.

2. Etching process according to claim 1, characterized in that the gaseous mixture has a pressure between 1 and 4 Pa.

3. Etching process according to claim 1 or 2, characterized in that the gaseous mixture is ionized by radiofrequency waves, the radiofrequency power being between 10 and 250 watts.

4. Etching process according to any one of the claims 1 to 3, characterized in that the material (2, 16, 36) is locally etched by using an etching mask (4a, 18, 38) representing the image of the zone (2a, 36a) to be etched.

5. Etching process according to claim 4,
characterized in that mask (4a) is of silicon nitride.

6. Etching process according to any one of the claims 1 to 5, characterized in that the III - V material (2, 10, 16, 36) is chosen from among InP, GaSb, $Ga_{1-x}In_xAs$, $Ga_{1-x}In_xAs_{1-y}P_y$, GaAs and $Ga_{1-x}Al_xAs$, with $0<x<1$ and $0<y<1$.

7. Process for the epitaxial growth of a semiconductor layer (10, 16, 28) of a first III - V material involving a stage of preparing the surface of the substrate, followed by a deposition stage by epitaxy, characterized in that the first stage consists of at least partly etching the substrate (2, 26) in accordance with any one of the claims 1 to 6.

**Patentansprüche**

1. Reaktives Ionenätzverfahren eines Materials III-V (2, 10, 16, 36) unter Verwendung einer Gasmischung, **dadurch gekennzeichnet**,
daß diese Mischung volumenmäßig enthält:
   - 20% Methan
   - 50% Argon, und
   - 30% Wasserstoff

2. Ätzverfahren nach Anspruch 1, dadurch gekennzeichnet, das die Gasmischung einen Druck aufweist, der enthalten ist zwischen 1 und 4 Pa.

3. Ätzverfahren nach Anspruch 1 oder 2, dadurch gekennzeichnet, daß die Gasmischung ionisiert wird mittels Radiofrequenzwellen, wobei die Radiofrequenzleistung von 10 bis 250 Watt geht.

4. Ätzverfahren nach einem der Ansprüche 1 bis 3, dadurch gekennzeichnet, daß man das Material (2, 16, 36) lokal ätzt unter Verwendung einer Ätzmaske (4a, 18, 38), die das Bild der zu ätzenden Zone (2a, 36a) darstellt.

5. Ätzverfahren nach Anspruch 4, dadurch gekennzeichnet, daß die Maske (4a) aus Siliciumnitrid ist.

6. Ätzverfahren nach einem der Ansprüche 1 bis 5, dadurch gekennzeichnet, daß das Material III-V (2, 10, 16, 36) gewählt wird aus InP, GaSb, $Ga_{1-x}In_xAs$, $Ga_{1-x}In_xAs_{1-y}P_y$, GaAs und $Ga_{1-x}Al_xAs$, mit $O \leqq x \leqq 1$ und $O \leqq y \leqq 1$.

7. Epitaxie-Wachstumsverfahren einer Halbleiterschicht (10, 13, 28) aus einem ersten Material III-V, das einen Vorbereitungsschritt der Substratoberfläche umfaßt, gefolgt von einem Abscheidungsschritt mittels Epitaxie, dadurch gekennzeichnet, daß der erste Schritt darin besteht, das Substrat (2, 26) wenigstens partiell zu ätzen, entsprechend einem beliebigen der Ansprüche 1 bis 6.

├───────────────────────────────┤ *12 μM*

**FIG. 1**   *InP*     *CH₄    15 %*
                      *H₂     65 %*
                      *Ar     20 %*

├───────────────────────────────┤ *12 μM*

**FIG. 2**   *InP*     *CH₄    15 %*
                      *H₂     30 %*
                      *Ar     55 %*

11

12 µM

FIG. 3

*InP*

CH4   10 %
H2    50 %
Ar    40 %

8 µM

FIG. 4

*InP*

CH4   40 %
H2    10 %
Ar    50 %

A

_14 µM

FIG. 5

CH4    20 %
H2    30 %
Ar    50 %

_9 µM

— GaInAS

— InP

FIG. 6

CH4    20 %
H2    30 %
Ar    50 %

.8 μM

FIG. 7  1Pa InP    CH₄  20%
                   H₂   30%
                   Ar   50%

8 μM

FIG. 8  4Pa InP

CH₄  20%
H₂   30%
Ar   50%

A

FIG 9

EP 0 292 390 B1

# FIG. 10

## a

6
4
2

## b

U.V

6a
Si₃N₄
4
2

## d

O₂

40
2

## c

CF₄

6a
4a
2

20
18
16
2
14

a

$[CH_3-C-CH_3]$
$\overset{\|}{O}$

16  21  22  24
2

b

# FIG. 12

FIG. 11

FIG. 13